# EUROPEAN PATENT APPLICATION

(11) **EP 3 769 876 A1**
(43) Date of publication of application: **27.01.2021**
(21) Application number: 19770835.7
(22) Date of filing: 15.03.2019
(51) Int. Cl.: B23B 27/14, C23C 16/36, C23C 16/40

(54) **TOOL AND CUTTING TOOL PROVIDED WITH SAME**

(30) Priority: 20.03.2018 JP 2018052842; 29.11.2018 JP 2018223531
(71) Applicant: Kyocera Corporation, Kyoto-shi, Kyoto 612-8501 (JP)
(72) Inventor: NOMIYAMA,Ryoma, Kyoto-shi, Kyoto 612-8501 (JP); TANAKA,Ayano, Kyoto-shi, Kyoto 612-8501 (JP)
(74) Representative: Viering, Jentschura & Partner mbB Patent- und Rechtsanwälte
(86) International application number: PCT/JP2019/010876
(87) International publication number: WO 2019/181791

(57) **Abstract**

An insert of the present disclosure includes a base made of a cermet containing a hard phase containing a carbonitride including Ti and a binder phase containing Co. The base contains CO_{0.93}W_{0.07}- A cutting tool of the present disclosure includes a holder extending from a first end to a second end and having a pocket on the first end side, and the insert positioned in the pocket positioned in pocket.

## Description

### Field

The present disclosure relates to a tool for use in a cutting process and a cutting tool including the same. Background

Cermets including titanium (Ti) as a main component are now widely used as bases of members requiring wear resistance, sliding property, and fracture resistance, such as cutting tools, wear-resistant members, and sliding members.

For example, Patent Literature 1 describes controlling firing conditions so that a first binder phase with a mass ratio of tungsten included in a metal phase in a cermet (W/(Co + Ni)) of 0.8 or less and a second binder phase with (W/(Co + Ni)) of 1.2 or more are present in the cermet.

The present invention is aimed to increase wear resistance and fracture resistance of cermets at high temperatures.

### Citation List

### Patent Literature

Patent Literature 1: Japanese Patent No. 5989930

### Summary

An insert of the present disclosure includes a base made of a cermet containing a hard phase containing a carbonitride including Ti and a binder phase containing Co. The base contains CO_{0.93}W_{0.07}. A cutting tool of the present disclosure includes a holder extending from a first end to a second end and having a pocket on the first end side, and the insert positioned in the pocket positioned in pocket.

### Brief Description of Drawings

FIG. 1 is a perspective view illustrating an example of an insert of the present disclosure.
FIG. 2 is an enlarged overview of a cross section in the vicinity of a surface of the insert of the present disclosure.
FIG. 3 is a plan view illustrating an example of a cutting tool of the present disclosure.

### Description of Embodiments

### <Insert>

An insert of the present disclosure will be described in detail below with reference to the drawings. The drawings hereinafter referred to are simplified to illustrate only the main members necessary for describing embodiments, for convenience of description. The insert of the present disclosure therefore may include any components not illustrated in the drawings referred to. The dimensions of members in the drawings do not exactly represent the actual dimensions of components or dimensional ratio between members. These points are applicable to a cutting tool described later.

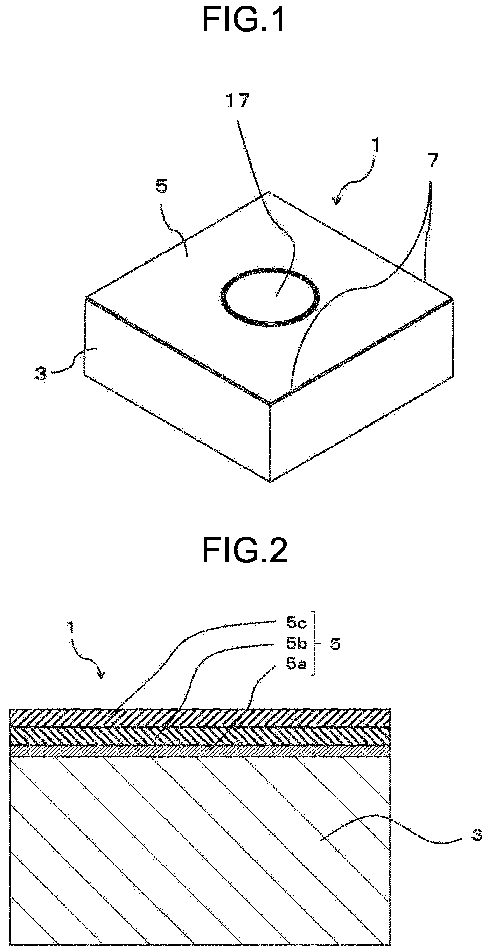

As illustrated in FIG. 1 and FIG. 2, an insert 1 of the present disclosure includes a base 3. The insert 1 of the present disclosure may include a coating layer 5 covering at least a part of the base 3.

The insert 1 of the present disclosure has, for example, a quadrangular plate shape, and its upper surface in FIG. 1 is a rake face. The insert 1 has a lower surface on the side opposite to the upper surface and a side surface between the upper surface and the lower surface to connect to each of the upper and lower surfaces. At least a part of the side surface is a flank face.

The insert 1 of the present disclosure has a cutting edge 7 positioned at at least a part of a ridge line where the upper surface and the side surface meet. In other words, the insert 1 has the cutting edge 7 positioned at at least a part of a ridge line where the rake face and the flank face meet.

In the insert 1, the entire outer perimeter of the rake face may serve as the cutting edge 7. However, the insert 1 is not limited to such a configuration and, for example, may have the cutting edge 7 at only one side, or partially, of the quadrangular rake face.

The size of the insert 1 is not limited and, for example, the length of one side of the rake face is set to about 3 to 20 mm. The thickness of the insert 1 is set, for example, to about 1 to 20 mm.

The base 3 of the insert 1 of the present disclosure is composed of a cermet containing a hard phase containing a carbonitride including Ti and a binder phase containing Co. The cermet is a TiCN-based cermet. Specifically, examples of the cermet include, but are not limited to, compounds containing TiC or TiN, etc. in addition to TiCN.

The base 3 in the insert 1 of the present disclosure contains CO_{0.93}W_{0.07}. The insert 1 excellent in wear resistance and fracture resistance thus can be obtained. C0_{0.93}W_{0.07} is a crystal represented in PDF:01-071-7509 of the JCPDS card.

If the amount of CO_{0.93}W_{0.07} included in the insert 1 is so small that C0_{0.93}W_{0.07} is unable to be specified, for example, by X-ray diffraction, the effects are not achieved.

In the insert 1 of the present disclosure, the proportion of C0_{0.93}W_{0.07} in all the crystals may be 5 to 10 in a crystalline phase analysis by X-ray diffraction. The proportion of CO_{0.93}W_{0.07} may be 8 to 10. When the CO_{0.93}W_{0.07} content is high in this way, the wear resistance and the fracture resistance of the base 3 are high.

The proportion of C0_{0.93}W_{0.07} above is obtained by calculating the proportion of C0_{0.93}W_{0.07} in the proportions of all the crystals detected by Rietveld refinement using an X ray system manufactured by PANalytical, X'Pert Pro 2θ: 10 to 100, and analysis software RIETAN-FP.

The base 3 may contain a total of 16 to 25 mass% of Co, Ni, and Fe.

In the base 3, the Co content obtained by Co/(Co + Ni + Fe) may be 99.0 mass% or more. In other words, this Co content may be represented as the Co content in the binder phase. The Co content may be 99.5 mass% or more. This Co content (mass%) is a value obtained by measuring the masses of Co, Fe, and Ni included in the insert, dividing the mass of Co by the total mass, and multiplying by 100. In other words, the total amount of Fe and Ni in the binder phase included in the insert 1 of the present disclosure may be less than 1 mass%. When a metal functioning as a binder phase is substantially Co alone in this way, Co_{0.93}W_{0.07} is distributed in the base 3 adequately, and the base 3 having high wear resistance and fracture resistance is easily obtained. When the binder phase is Co alone, for example, the mean particle size as a raw material powder of the hard phase may be 1 µm or less, further 0.6 µm or less. The Co content in the base 3 may be 16 mass% or more.

When Fe and Ni are included as the binder phase, the wettability between the hard phase and the binder phase is improved.

The binder phase may take up 5 to 25 area% in a cross section of the base 3. The binder phase may be composed of Co and W only, except inevitable impurities. When the binder phase contains elements other than Co and W, each element content may be 0.5 mass% or less.

As illustrated in FIG. 2, the insert 1 of the present disclosure may include the coating layer 5 on the base 3. When the insert 1 includes the coating layer 5, the wear resistance of the insert 1 is high.

The coating layer 5 may be formed, for example, by a CVD process or a PVD process. The coating layer 5 may include, for example, a first layer 5a containing TiN particles on the side closer to the base 3. The coating layer 5 may include a second layer 5b including TiCN particles at a position more distant from the base 3 than the first layer 5a and include a third layer 5c including Al₂O₃ particles at a position more distant from the base 3 than the second layer 5b.

When the first layer 5a includes a plurality of TiN particles, the width of TiN particles in a direction parallel to a surface of the base 3 (hereinafter also referred to as the width of TiN particles) may be 5 to 20 nm in a cross section vertical to the surface of the base 3. With such a configuration, the adhesion between the first layer 5a and the base 3 is excellent. Since the width of particles of the coating film 5 is small, the wear resistance of the coating film 5 is high.

The width of TiN particles may be measured at a position 0.05 µm from the surface of the base 3. When the thickness of the first layer 5a is 0.05 µm or less, the width of TiN particles may be measured at a position half the thickness of the first layer 5a.

The ratio (which hereinafter may be referred to as aspect ratio) of the height of TiN particles in a direction vertical to the surface of the base 3 to the width of TiN particles in a direction parallel to the surface of the base 3 may be 1.0 to 1.7. With such a configuration, the adhesion force between the first layer 5a and the base 3 is excellent.

The aspect ratio of TiN particles may be measured from TiN particles present at a position up to 0.05 µm from the surface of the base 3.

The thickness of the first layer 5a may be 0.1 to 1.0 µm. When the thickness of the first layer 5a is 0.1 µm or more, diffusion of the binder phase component included in the base 3 to the coating is suppressed, and the fracture resistance is excellent. When the thickness of the first layer 5a is 1.0 µm or less, the TiCN particles included in the upper layer, that is, the second layer 5b are finer, and the wear resistance is excellent. In particular, the thickness of the first layer 5a may be 0.3 to 0.7 µm.

In the example illustrated in FIG. 2, the insert 1 includes the first layer 5a on the base 3. The insert 1 includes the second layer 5b on the first layer 5a. The second layer 5b includes TiCN particles. The thermal expansion coefficient of the TiCN particles is about 8 × 10⁻⁶/°C, and when the thermal expansion coefficient of the base 3 is 9.0 × 10⁻⁶/°C or more, the thermal expansion coefficient of the second layer 5b is smaller than the thermal expansion coefficient of the base 3. The second layer 5b is interposed between the base 3 and the first layer 5c to suppress peeling of the first layer 5c and suppress abrasive wear.

The third layer 5c includes Al₂O₃ particles. The thermal expansion coefficient of the Al₂O₃ particles is about 7.2 × 10⁻⁶/°C and is smaller than the thermal expansion coefficients of the base 3 and the second layer 5b. The base 3 and the second layer 5b may be in direct contact or, for example, the first layer 5a may be positioned between them as in the example in FIG. 2. The first layer 5a is not necessarily composed of pure TiN particles alone and may contain, for example, O and/or C. The second layer 5b and the third layer 5c may be in direct contact or, for example, a TiN layer (not illustrated) may be positioned between them.

In the insert 1 having such a configuration, an adequate compressive stress can be exerted on the second layer 5b and the third layer 5c by adjusting the thermal expansion coefficient of the base 3 and the thickness of the third layer 5c. For example, the thickness of the third layer 5c is 2 µm or more.

Then, the compressive stress exerted on the second layer 5b may be 250 to 500 MPa, the compressive stress exerted on the third layer 5c may be 450 MPa or more, and the value of the compressive stress exerted on the third layer 5c may be larger than the compressive stress exerted on the second layer 5b. The insert 1 having such a configuration is excellent in wear resistance and durability.

The compressive stresses exerted on the second layer 5b and the third layer 5c may be determined, for example, based on measurement using a 2D method. Specifically, a section of the flank face, 1 mm or more away from the cutting edge 7, is set as a measurement location, and X-ray diffraction peaks are measured. For the crystal structure specified from the measurement result, the compressive stress can be obtained by determining how the value of 2θ in the measurement result deviates from the value of 2θ serving as a standard described in the JCPDS card.

When a residual stress has a negative value, the residual stress is compressive stress. When the value of compressive stress is expressed, it is represented by an absolute value with no minus sign.

As the thermal expansion coefficient of the base 3 increases, the values of the compressive stresses exerted on the second layer 5b and the third layer 5c tend to increase.

When the second layer 5b and the third layer 5c that constitute the coating layer 5 are compared, the third layer 5c is at a position more distant from the base 3. When a workpiece is processed using the cutting tool 1 of the present disclosure, therefore, the third layer 5c comes into contact with the workpiece before the second layer 5b. When the third layer 5c includes Al₂O₃ particles and has a thickness of 2 µm or more, the wear resistance and the oxidation resistance are high. The thickness of the third layer 5c may be 2.5 µm or more and 8.0 µm or less. The insert 1 having such a configuration is more excellent in wear resistance and oxidation resistance.

In consideration of the functions of the second layer 5b and the third layer 5c, the sum of the thickness of the second layer 5b and the thickness of the third layer 5c may be 7 µm or more and 18 µm or less. The sum of the thicknesses may be 8 µm or more and 16 µm or less.

The second layer 5b may have a thickness of 5 µm or more and 10 µm or less. With such a range, the wear resistance and the fracture resistance of the insert 1 are excellent.

The thickness of the third layer 5c may be 0.2 to 0.4 times the sum of the thickness of the second layer 5b and the thickness of the third layer 5c. The insert 1 having such a configuration is excellent in wear resistance and fracture resistance.

The C axis of Al₂O₃ crystals of the third layer 5c may be oriented along a direction vertical to a main surface of the base 3. To put it another way, the third layer 5c may contain α-Al₂O₃ particles, and the α-Al₂O₃ crystals may be shaped like a column extending in the vertical direction relative to the main surface of the base 3.

In the base 3 in the insert 1 of the present disclosure, a binder phase-enriched layer may be present on the surface, which has a higher proportion of the binder phase compared with the inside of the base 3. The thickness of the binder phase-enriched layer may be 1 µm or more and 10 µm or less.

A method of producing the insert of the present disclosure will be described below.

Table 1 illustrates the proportions of raw material powders to form the base of the insert used in Examples described later. The mean particle size of each raw material is 1 µm or less.

These raw material powders are typically used in production of cermets. C0_{0.93}W_{0.07} included in the insert of the present disclosure is formed by allowing Co and W used as raw materials to react in a production process of the insert.

In preparation of raw materials, the amount of C contained is adjusted to obtain the base containing CO_{0.93}W_{0.07}. The amount of C in the raw materials is set such that the prepared composition ratio is C/(hard phase) = 8.0 to 9.1. With C/(hard phase) of 9.1 or less, the base containing C0_{0.93}W_{0.07} can be obtained. With C/ (hard phase) of 8.0 or more, increase in η phase can be suppressed, and relative reduction of C0_{0.93}W_{0.07} can be suppressed.

The amount of C in the raw materials includes, for example, C included in the raw material powders, in addition to C added as carbon. The hard phase refers to the one that may be present as a hard phase in an insert and does not include, for example, metals, oxides, or carbonates of Fe, Ni, Co, Mn, and/or Mo.

After a binder is added to the raw material powder having such a composition range, for example, the powder is formed into a desired shape by press molding and subjected to a debindering step for removing the binder component, and thereafter fired in a nitrogen or vacuum atmosphere in a temperature range of 1500 to 1550°C to produce a highly dense base.

At the debindering step, the product is held in a vacuum at 200°C and 300°C each for 1 hour, and then the temperature is increased to 450°C and held for 1 hour. At the step at 450°C, in order to suppress reduction of C added as a raw material, CO₂ gas is introduced into a debindering furnace at a pressure of 1 to 5 kPa. In this way, the amount of C can be precisely controlled.

The base may have a thermal expansion coefficient at 25 to 1000°C of 9.0 × 10⁻⁶/°C or more.

Subsequently, a coating layer may be provided, if necessary. When a coating layer is provided, for example, a first layer containing TiN particles is formed on a surface of the base. A second layer containing TiCN particles is further formed on the first layer. A third layer containing Al₂O₃ particles is further formed on the second layer. The first layer, the second layer, and the third layer may be formed by a chemical vapor deposition (CVD) process. With this CVD process, the higher the deposition temperature is in depositing a film, the greater the compressive stress is exerted on the deposited film. The deposition temperature is then adjusted, if necessary.

In order to obtain the first layer having fine TiN particles with a width of less than 20 nm in a direction parallel to the surface of the base in a cross section vertical to the surface of the base, the ratio of Co in the binder phase components included in the base may be 99.9 mass% or more.

The first layer may be deposited, for example, at a temperature of 800 to 900°C, a pressure of 8 to 20 kPa, a TiCl₄ concentration of 0.2 to 2.5 mol%, a N₂ concentration of 25.0 to 49.9 mol%, and a H₂ concentration of 40.0 to 74.8 mol%.

The compressive stresses exerted on the second layer and the third layer can be suppressed also by controlling the thicknesses of the second layer and the third layer as described above.

The compressive stresses of the second layer and the third layer of the produced insert are once measured, and then the deposition temperature and/or the deposition time is adjusted based on the result so that the insert having a desired compressive stress can be produced.

### <Cutting Tool>

The cutting tool of the present disclosure will now be described with reference to the drawings.

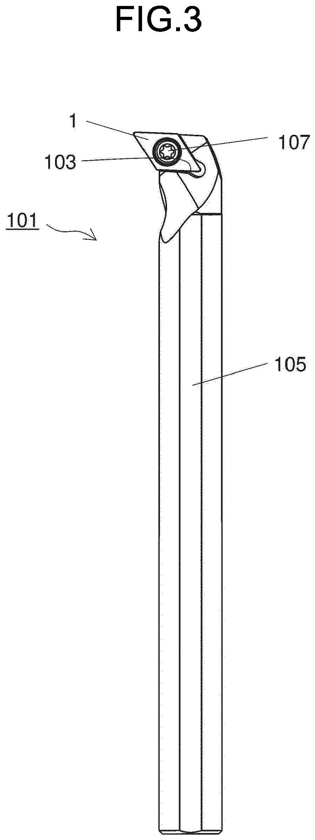

As illustrated in FIG. 3, a cutting tool 101 of the present disclosure is, for example, a rod-shaped body extending from a first end (the upper end in FIG. 3) to a second end (the lower end in FIG. 3). As illustrated in FIG. 3, the cutting tool 101 includes a holder 105 having a pocket 103 on the first end side (tip end side) and the aforementioned insert 1 positioned in the pocket 103. Because of the provision of the insert 1, the cutting tool 101 can perform a stable cutting process over a long time period.

The pocket 103 is a portion to which the insert 1 is attached and has a seat surface parallel to a lower surface of the holder 105 and a constraint side surface inclined relative to the seat surface. The pocket 103 is open on the first end side of the holder 105.

The insert 1 is positioned in the pocket 103. The lower surface of the insert 1 may be in direct contact with the pocket 103 or a sheet (not illustrated) may be sandwiched between the insert 1 and the pocket 103.

The insert 1 is attached to the holder 105 such that at least a part of a section used as the cutting edge 7 at the ridge line on which the flank face and the rake face meet protrudes outward from the holder 105. In the embodiments, the insert 1 is attached to the holder 105 by a fixing screw 107. That is, the insert 1 is attached to the holder 105 by inserting the fixing screw 107 into a through hole 17 of the insert 1, inserting a tip end of the fixing screw 107 into a screw hole (not illustrated) formed in the pocket 103, and screwing the screw portions together.

For example, steel and cast iron can be used as the material of the holder 105. Among these materials, steel with a high toughness may be used.

In the embodiments, a cutting tool for use in a turning process is illustrated by way of example. Examples of the turning process include, but are not limited to, a boring process, an external process, a grooving process, and a facing process. The cutting tool is not limited to the one for use in the turning process. For example, the insert 1 in the foregoing embodiments may be used for a cutting tool for use in a milling process.

### Examples

The insert of the present disclosure will be described below.

The base was produced as follows. A molded product in the shape of a tool was produced using raw material powders in proportions indicated in Table 1, and a binder component was removed, followed by firing to produce a base. Among these samples, the bases of Sample Nos. 1 to 14 are a cermet. The base of Sample No. 15 is a superalloy. At the debindering step, the product was held in a vacuum at 200°C and 300°C each for 1 hour, and then the temperature was increased to 450°C and held for 1 hour. At the step at 450°C, CO₂ gas was introduced at a pressure of 3 kPa into a debindering furnace.

**Table 1**

| Sample No. | Base | | | | | | | | | | | | | | |
|---|---|---|---|---|---|---|---|---|---|---|---|---|---|---|---|
| | Amount prepared [mass%] | | | | | | | | | | | Co/(Co+ Ni) (mass%) | C/(hard phase) [-] | Amount of CO_{0.93} W_{0.07} [%] | Thermal expansion coefficient [ × 10^{~6} (/°C) ] |
| | TiCN | TiN | WC | NbC | VC | MO₂C | MnCO₃ | ZrC | Co | Ni | C | | | | |
| 1 | 28.2 | 17.8 | 20.9 | 7.9 | 1.6 | 0.6 | 0.8 | 0.2 | 15.0 | 4.9 | 2.1 | 75.4 | 9.20 | 0.0 | 9.26 |
| 2 | 28.3 | 17.8 | 21.0 | 7.9 | 1.6 | 0.6 | 0.8 | 0.2 | 20.0 | 0.0 | 1.8 | 100.0 | 8.90 | 2.6 | 9.32 |
| 3 | 28.5 | 18.0 | 21.2 | 8.0 | 1.6 | 0.6 | 0.8 | 0.2 | 20.1 | 0.0 | 1.0 | 100.0 | 7.90 | 7.6 | 9.30 |
| 4 | 42.2 | 16.6 | 19.4 | 8.6 | 1.6 | 0.6 | 0.8 | 0.2 | 9.0 | 0.0 | 1.0 | 100.0 | 8.28 | 1.2 | 9.10 |
| 5 | 41.8 | 10.0 | 21.1 | 7.9 | 1.6 | 0.6 | 0.8 | 0.2 | 16.0 | 0.0 | 0.0 | 100.0 | 8.40 | 2.3 | 9.18 |
| 6 | 46.8 | 10.0 | 21.0 | 8.0 | 1.6 | 0.6 | 0.8 | 0.2 | 6.0 | 5.0 | 0.0 | 54.5 | 7.57 | 0.0 | 9.20 |
| 7 | 41.2 | 8.3 | 21.0 | 7.9 | 1.6 | 0.6 | 0.8 | 0.2 | 18.2 | 0.0 | 0.3 | 100.0 | 8.33 | 3.8 | 9.28 |
| 8 | 40.0 | 8.1 | 20.4 | 7.7 | 1.6 | 0.6 | 0.8 | 0.2 | 20.6 | 0.0 | 0.3 | 100.0 | 8.34 | 9.8 | 9.31 |
| 9 | 40.0 | 8.1 | 20.4 | 7.7 | 1.6 | 0.6 | 0.8 | 0.2 | 20.6 | 0.0 | 0.3 | 100.0 | 8.34 | 9.8 | 9.31 |
| 10 | 40.0 | 8.1 | 20.4 | 7.7 | 1.6 | 0.6 | 0.8 | 0.2 | 20.5 | 0.1 | 0.3 | 99.5 | 8.34 | 8.4 | 9.33 |
| 11 | 40.0 | 8.1 | 20.4 | 7.7 | 1.6 | 0.6 | 0.8 | 0.2 | 20.0 | 0.6 | 0.3 | 97.1 | 8.34 | 5.1 | 9.35 |
| 12 | 57.2 | 7.5 | 14.6 | 0.0 | 0.0 | 0.0 | 0.0 | 0.0 | 20.7 | 0.0 | 0.0 | 100.0 | 8.23 | 10.9 | 9.02 |
| 13 | 56.3 | 7.5 | 14.6 | 0.0 | 0.0 | 0.0 | 0.0 | 0.0 | 21.6 | 0.0 | 0.0 | 100.0 | 8.21 | 12.1 | 9.06 |
| 14 | 55.4 | 7.5 | 14.6 | 0.0 | 0.0 | 0.0 | 0.0 | 0.0 | 22.5 | 0.0 | 0.0 | 100.0 | 8.19 | 14.6 | 9.17 |
| 15 | 0.0 | 0.0 | ^ | 0.0 | 0.0 | 0.0 | 0.0 | 0.0 | 10.0 | 0.0 | 0.0 | 100.0 | 6.13 | 0 | 6.08 |

**Table 2**

| Sample No. | TiN layer deposition condition 850°C, 16kPa | | | TiN layer | | Compressive stress σ 11[MPa] | | Film thickness [µm] | | | Film thickness ratio | Cutting performance | |
|---|---|---|---|---|---|---|---|---|---|---|---|---|---|
| | H₂ concentration [mol.%] | N₂ concentration [mol.%] | TiCl₄ concentration [mol.%] | Width of TiN particles (nm) | Aspect ratio | | | | | | | Amount of flank face wear [µm] | Number of impacts until chipping occurs |
| | | | | | | TiCN | Al₂O₃ | TiCN | Al₂O₃ | TiCN+ Al₂O₃ | Al₂O₃ / (Al₂O₃ +TiCN) | | |
| 1 | 49.7 | 49.7 | 0.6 | 56 | 0.6 | -301 | -511 | 7.78 | 3.52 | 11.30 | 0.31 | 90 | 15356 |
| 2 | 49.8 | 49.8 | 0.4 | 14 | 1.4 | -315 | -502 | 7.60 | 3.74 | 11.34 | 0.33 | 81 | 30013 |
| 3 | 49.1 | 49.1 | 1.8 | 15 | 1.5 | -349 | -498 | 7.41 | 3.87 | 11.28 | 0.34 | 84 | 31514 |
| 4 | 49.5 | 49.5 | 1.0 | 12 | 1.9 | -341 | -492 | 7.52 | 3.98 | 11.50 | 0.35 | 89 | 20341 |
| 5 | 49.5 | 49.5 | 1.0 | 12 | 1.7 | -296 | -483 | 7.57 | 4.01 | 11.58 | 0.35 | 72 | 38613 |
| 6 | 49.8 | 49.8 | 0.4 | 43 | 0.8 | -311 | -516 | 7.65 | 3.41 | 11.06 | 0.31 | 119 | 11742 |
| 7 | 49.7 | 49.7 | 0.6 | 13 | 1.5 | -342 | -513 | 7.43 | 3.56 | 10.99 | 0.32 | 76 | 31062 |
| 8 | 49.3 | 49.3 | 1.5 | 15 | 1.3 | -429 | -607 | 7.76 | 2.68 | 10.44 | 0.26 | 65 | 42917 |
| 9 | 49.9 | 49.9 | 0.3 | 15 | 1.7 | -422 | -599 | 7.15 | 3.23 | 10.38 | 0.31 | 78 | 35156 |
| 10 | 49.8 | 49.8 | 0.4 | 24 | 1.0 | -250 | -632 | 9.84 | 6.31 | 16.15 | 0.39 | 79 | 36134 |
| 11 | 49.8 | 49.8 | 0.4 | 35 | 0.9 | -203 | -553 | 11.74 | 2.06 | 13.80 | 0.15 | 81 | 29561 |
| 12 | 49.8 | 49.8 | 0.4 | 15 | 1.4 | -250 | -468 | 9.84 | 6.31 | 16.15 | 0.39 | 75 | 25313 |
| 13 | 49.8 | 49.8 | 0.4 | 17 | 1.3 | -271 | -632 | 8.61 | 1.82 | 10.43 | 0.17 | 84 | 23613 |
| 14 | 49.8 | 49.8 | 0.4 | 18 | 1.1 | -279 | -588 | 8.42 | 2.57 | 10.99 | 0.23 | 88 | 20641 |
| 15 | 49.8 | 49.8 | 0.4 | 39 | 3.6 | 509 | 531 | 7.29 | 3.45 | 10.74 | 0.32 | 196 | 20086 |

On a surface of this base, a first layer was formed under the deposition conditions indicated in Table 2 by a CVD process under the deposition condition indicated in Table 2. On the first layer, a second layer was further formed. On the second layer, a third layer was further formed.

The presence/absence of C0_{0.93}W_{0.07} in the base is indicated in Table 1. In a cross section vertical to the surface of the base of the resulting insert, the width of TiN particles in a direction parallel to the surface of the base in the first layer and the aspect ratio of TiN particles were measured. The results are illustrated in Table 2. The base had a binder phase-enriched layer.

The resulting insert underwent a cutting test under the following conditions.

### (Wear Resistance Test)

Workpiece material: SAPH440
Cutting speed: 1000 m/min
Feed: 0.15 mm/rev
Depth of cut: 0.25 mm
Cutting state: wet
Evaluation method: flank face wear width (µm) at the point of time when a cutting length of 5.0 km was cut

### (Chipping Resistance Test)

Workpiece material: SAPH440 with 12 grooves (10 mm wide)
Cutting speed: 1000 m/min
Feed: 0.15 mm/rev
Depth of cut: 0.25 mm
Cutting state: wet
Evaluation method: the number of impacts until fracture

In a cross section of the resulting insert, the presence/absence of C0_{0.93}W_{0.07} and the proportion thereof were determined by X-ray diffraction. The results are illustrated in Table 1. The width of TiN particles in a direction parallel to the surface of the base in the first layer was measured. The results are illustrated in Table 2. Table 2 also illustrates the aspect ratio of TiN particles.

The resulting insert underwent a cutting test under the following conditions.

### (Wear Resistance Test)

Workpiece material: SAPH440
Cutting speed: 1000 m/min
Feed: 0.15 mm/rev
Depth of cut: 0.25 mm
Cutting state: wet
Evaluation method: flank face wear width (µm) at the point of time when a cutting length of 5.0 km was cut

### (Chipping Resistance Test)

Workpiece material: SAPH440 with 12 grooves (10 mm wide) Cutting speed: 1000 m/min
Feed: 0.15 mm/rev
Depth of cut: 0.25 mm
Cutting state: wet
Evaluation method: the number of impacts until fracture

Sample No. 15 using superalloy as a base does not contain CO_{0.93}W_{0.07}.

Samples Nos. 2 to 5 and 7 to 14 that are inserts including a base containing C0_{0.93}W_{0.07} exhibit more excellent wear resistance and fracture resistance than Sample Nos. 1, 6, and 15 that do not include CO_{0.93}W_{0.07}.

In a crystalline phase analysis by X-ray diffraction of the base, Sample Nos. 3 and 8 to 13 in which the proportion of C0_{0.93}W_{0.07} in all the crystals is in a range of 5 to 12 exhibit particularly excellent wear resistance and fracture resistance.

The samples in which the width of TiN particles of the first layer is 20 nm or less are excellent in adhesion between the base and the first layer. The samples in which the aspect ratio is 1.0 to 1.7 or less are excellent in adhesion between the base and the first layer. Reference Signs List

- 1: insert
- 3: base
- 5: coating film
- 5a: first layer
- 5b: second layer
- 5c: third layer
- 7: cutting edge
- 17: through hole
- 101: cutting tool
- 103: pocket
- 105: holder
- 107: fixing screw

## Claims

1. An insert comprising a base made of a cermet containing:
a hard phase containing a carbonitride including Ti; and
a binder phase containing Co, wherein
the base contains CO_{0.93}W_{0.07}.

2. The insert according to claim 1, wherein a proportion of the C0_{0.93}W_{0.07} in all crystals is 5 to 12 in a crystalline phase analysis by X-ray diffraction of the base.

3. The insert according to claim 1 or 2, wherein the base contains a total of 16 to 25 mass% of the Co, Ni, and Fe.

4. The insert according to any one of claims 1 to 3, wherein a Co content of the base obtained by Co/(Co + Ni + Fe) is 99.0 mass% or more.

5. The insert according to any one of claims 1 to 4, wherein the base has a coating layer on at least a part of a surface.

6. The insert according to claim 5, wherein the coating layer includes a first layer having a plurality of TiN particles on the base side, and in a cross section vertical to a surface of the base, a width of the TiN particles in a direction parallel to the surface of the base is 20 nm or less.

7. The insert according to claim 5 or 6, wherein in a cross section vertical to a surface of the base, a ratio of a height of the TiN particles in a direction vertical to the surface of the base to a width of the TiN particles in a direction parallel to the surface of the base is 1.0 to 1.7.

8. The insert according to any one of claims 5 to 7, wherein the coating layer includes a second layer including TiCN particles at a position more distant from the base than the first layer, and a third layer including Al₂O₃ particles at a position more distant from the base than the second layer.

9. The insert according to claim 8, wherein
the base has a thermal expansion coefficient at 25 to 1000°C of 9.0 × 10⁻⁶/°C or more,
the second layer has a compressive stress of 250 to 500 MPa, and
the third layer has a thickness of 2 µm or more and a compressive stress of 450 MPa or more, and a value of the compressive stress is greater than the compressive stress of the TiCN layer.

10. The insert according to claim 8 or 9, wherein the third layer has a thickness of 2.5 µm or more and 8.0 µm or less.

11. The insert according to any one of claims 8 to 10, wherein the second layer has a thickness of 5 µm or more and 10 µm or less.

12. The insert according to any one of claims 8 to 11, wherein a thickness of the third layer is in a range of 0.2 to 0.4 times a sum of the thickness of the second layer and the thickness of the third layer.

13. A cutting tool comprising:
a holder extending from a first end to a second end and having a pocket on the first end side; and
the insert according to any one of claims 1 to 12 positioned in the pocket.
